# EUROPEAN PATENT APPLICATION

(11) **EP 2 325 867 A1**
(43) Date of publication of application: **25.05.2011**
(21) Application number: 09176950.5
(22) Date of filing: 24.11.2009
(51) Int. Cl.: H01L 21/02, H01L 21/285

(54) **High-dielectric constant capacitor**

(71) Applicant: NXP B.V., 5656 AG Eindhoven (NL)
(72) Inventor: Roest, Aarnoud, 5656 AE, Eindhoven (NL); Van Leuken-Peters, Linda, 5656 AE, Eindhoven (NL)
(74) Representative: Williamson, Paul Lewis

(57) **Abstract**

A method of manufacturing a capacitor (18) is presented. The method comprises forming a capacitor having a high-k dielectric layer (20) sandwiched between top (22) and bottom (24) electrodes, the high-k dielectric layer (20) having a dielectric constant greater than 20. The capacitor (18) is then covered with an encapsulation layer (28) so as to protect the high-k dielectric layer (20) from a subsequent annealing process

## Description

This invention relates to semiconductor devices, and more particularly to a high-dielectric constant capacitor.

In the case of capacitors, the main focus is on the development of high capacitance/area devices with low series resistance of the top and bottom electrodes for high frequency responses. High capacitance/area devices require the use of dielectric materials that are thin (of the order of about 200 A or less). The use of conventional, thin low-k dielectrics (having a dielectric constant, k, of about 20 or below) in today's devices is undesirable since such materials lead to leaky devices.

With the use of high-k dielectrics (having a dielectric constant, k, of greater than 20, and typically in the range of k=900-1600), the space needed for an integrated capacitor becomes much smaller when compared to lower-k materials. Thus, the integration of High-K (HK) capacitors with Bipolar Complimentary Metal Oxide Semiconductor (BiCMOS) technology provides a way to introduce high-density capacitors within High-K technology.

The problem with combining these technologies is the fact that high-K capacitors do not survive the (400-450°C) forming gas (N₂-H₂) annealing step which is normally used as a final step in BiMOS (and related technologies). Also, tungsten (W) plugs that are typically needed to contact the transistors in BiMOS do not survive the high temperature anneal in an oxygen ambient used in High-K technology (700-800°C).

Accordingly, it is desirable to develop a way to combine High-K technologies with BiMOS (and related technologies) which addresses the aforementioned integration difficulties.

According to the invention, there is provided a method of manufacturing a capacitor comprising the steps of: forming a capacitor having a high-k dielectric layer sandwiched between top and bottom electrodes, the high-k dielectric layer having a dielectric constant greater than 20; and covering the capacitor with an encapsulation layer so as to protect the high-k dielectric layer from a subsequent annealing process.

The encapsulation layer may protect the high-K dielectric material from the annealing process(es) typically used as a final step in BiMOS. By being protected from an annealing process, the dielectric constant of a capacitor according to the invention may be maintained at a high value.

Embodiments therefore enable the integration of High-K capacitors with BiCMOS, BiMOS, CMOS or Bipolar junction transistors while maintaining a high dielectric constant, k, value of, for example, PZT (for example, in the range of 900-1600). In this way, the space needed for integrated capacitors is much smaller with respect to the conventional use of lower-k materials.

Embodiments may provide a capacitance density of 20-100 nF/mm2 which is larger than resultant from conventional techniques employing dielectric lower-k material (having a dielectric constant less than 20, for example).

According to another aspect of the invention, there is provided a capacitor having a high-k dielectric layer sandwiched between top and bottom electrodes, the high-k dielectric layer having a dielectric constant greater than 20, the capacitor being characterised by comprising an encapsulation layer adapted to protect the high-k dielectric layer from an annealing process. Such a capacitor may therefore be combined with BiCMOS, BiMOS, CMOS or BJT technology whilst maintaining a high dielectric constant value of the dielectric layer.

The high-k dielectric layer may have a dielectric constant greater than 100 and more preferably greater than 500.

According to yet another aspect, there is provided a semiconductor device comprising: a substrate; and a capacitor according to an embodiment formed on the substrate.

Examples of the invention will now be described with reference to the accompanying drawings, in which:

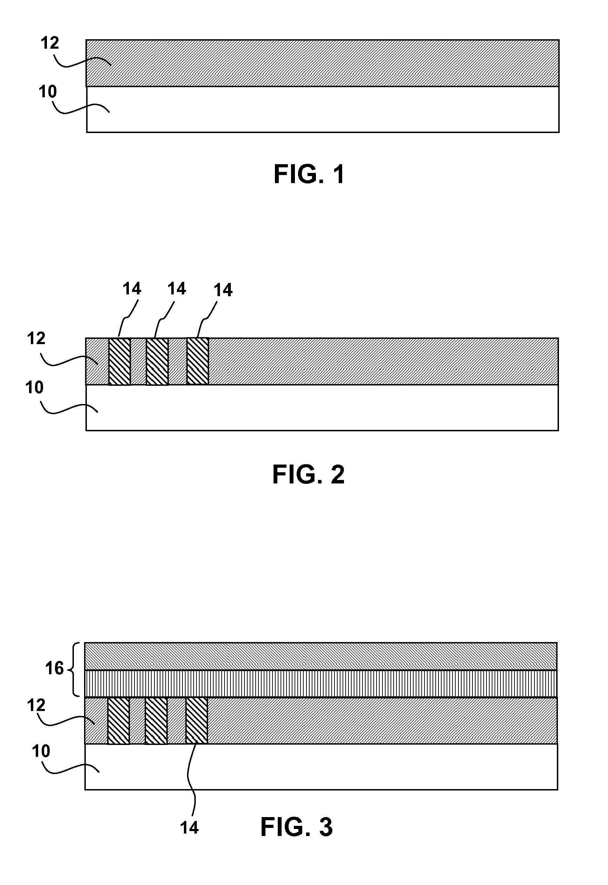

Figures 1-7 shows are cross-sectional views of a semiconductor device through various processing steps of the present invention.

The drawings are not to scale, and some dimensions may have been exaggerated (for example the thickness dimension) to make the drawings show the different components more clearly. It is also noted that the drawings only show a portion of a device. The bipolar device region and the region containing the device transistors are not shown for simplicity. However, as one skilled in the art is aware, the bipolar devices and the device transistors may be formed in the areas that abut the capacitor area depicted in the drawings.

Reference is made to Figures 1-7 which illustrate the formation of a capacitor structure according to an embodiment of the invention.

Figure 1 shows a cross-section of a portion (i.e. the area of the device in which the capacitor is to be formed) of Si-containing substrate 10 after the formation/deposition of a tetra-ethyl-ortho-silicate (TEOS) layer 12 on an upper surface of the Si-containing substrate 10 at a high temperature (of about 700°C).

The structure shown in Figure 1 is composed of conventional materials well known to those skilled in the art and conventional BiCMOS or CMOS processing steps are used in forming the same.

For example, Si-containing substrate 10 includes any Si-containing semiconducting material such as Si, SiGe, Si/Si, Si/SiGe, polysilicon, silicon-on insulators (SOls) or combinations thereof such as a layer of polysilicon formed on a Si substrate. Preferred Si-containing substrates are Si and polysilicon substrates. The Si-containing substrate may include various active devices and/or isolation regions formed therein. For clarity, the active devices and/or isolation regions are not shown in FIG. 1A, but are meant to be included by reference numeral 10. The Si-containing substrate may of the p- or n-type depending on the type of devices being fabricated thereon.

Next, as shown in Figure 2, a plurality of tungsten (W) plugs 14 are formed in the TEOS layer 12 (covering the Si substrate including the bimos/cmos etc.) so as to contact the transistors or other functionality in the substrate 10. In this process, contact holes are formed in the TEOS layer 12 by plasma etching. Next, after an in-situ cleaning step, an adhesion layer of typically 20 nm Ti and a barrier layer of 80 nm TiN is deposited over the entire structure. Ti is deposited preferably by PVD (sputtering), the TiN layer can be deposited by PVD (reactive sputtering) or MOCVD at elevated temperature (∼350 - 400°C). The W plugs are formed by deposition of W by CVD primarily from WF6 and H₂ in the temperature range of 350 ― 450°C, After deposition, the W film is etched back / CMP-ed back down to the surface of layer 12, leaving W plugs in the contacts.

Referring to Figure 3, the W plugs are then covered by a bi-layer 16 (or stack) of SiN-TEOS or SiON-TEOS (this means Silicon nitride or siliconoxinitride, so a mixture of oxide and nitride). This is to create a stack with two different materials which will form a barrier, so holes in the first layer will not continue in the second layer.

The layers are then subjected to an annealing process which is typically carried out in an N₂ and/or O₂ atmosphere in a furnace at 500-700°C. This anneal process is followed by a Rapid Thermal Annealing (RTA) process. This procedure is followed to densify the stack/bi-layer 16 to make sure it cannot be penetrated by oxygen at the high RTA temperatures used for the PZT annealing. The RTA anneal before the PZT depositions is to make sure that no outgassing will occur from layer 16 during the RTA anneal after the PZT deposition. This encapsulation ensures that the W plugs will survive a subsequent PZT annealing procedure.

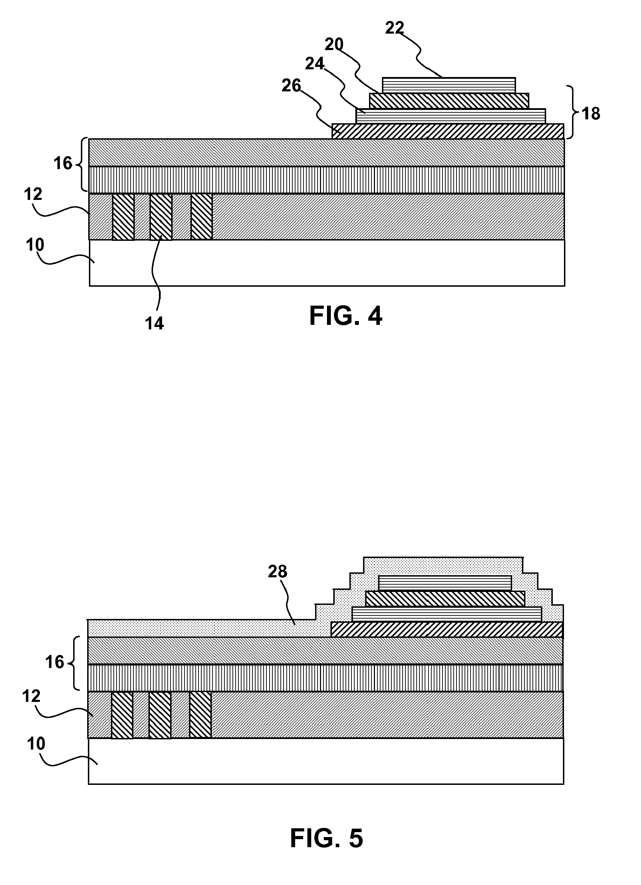

Next, and as shown in FIG. 4, one or more capacitors 18 are formed over at least a portion of the bi-layer 16. Specifically, the capacitors 18 are formed by sandwiching a first high-k PZT dielectric layer 20 between top 22 and bottom 24 electrode layers, wherein the bottom electrode layer 24 is separated from the bi-layer 16 by a second high-k dielectric layer 26. Here, for the second high-k dielectric layer 26, TiOₓ-Ti or TiOₓ-PZT or TiOₓ is used, this layer does not have to be high-k but it may be favourable to use PZT because it can act as an extra H₂ protection for the real dielectric).

The term "high-k" as used herein denotes a dielectric that has a dielectric constant of greater than 20, preferably greater than 50, more preferably greater than 100 and even more preferably greater than 500. It is noted that all the dielectric constants reported herein are relative to a vacuum having a dielectric constant of 1.

A wide variety of high-k dielectrics may be employed in the present invention including, but not limited to: binary metal oxides such as TiO₂ Ta₂O₅ A1₂O₃, Y₂O₃, ZrO₂, HfO₂, Gd₂O₃, and La₂O₃; silicates, aluminates and oxynitrides of said binary metal oxides; and perovskite-type oxides. Combinations and/or multilayers of such high-k dielectrics may also be employed. The perovskite-type oxides may be in the crystalline or amorphous phase.

Examples of perovskite-oxides that may be employed in the present invention as the high-k dielectric material include, but are not limited to: a titanate system material, i.e., barium titanate, strontium titanate, barium strontium titanate (BST), lead titanate, lead zirconate titanate (PZT), lead lanthanum zirconate titanate, barium zirconium titanate and barium lanthanum titanate; a niobate or tantalate system material such as lead magnesium niobate, lithium niobate, lithium tantalate, potassium niobate, strontium aluminum tantalate and potassium tantalum niobate; a tungsten-bronze system material such as barium strontium niobate, lead barium niobate, and barium titanium niobate; or a Bi-layered perovskite system material such as strontium bismuth tantalate, and bismuth titanate.

Of the various high-k dielectrics mentioned above, preference is given to PZT or BST for layer 20. Also doped versions of PZT and BST can be used.

The layers of the capacitors 18 may be formed utilizing any conventional deposition process, including, but not limited to: low-pressure chemical vapour deposition (LPCVD), atomic layer chemical vapour deposition (ALCVD), rapid thermal chemical vapour deposition (RTCVD), plasma-assisted CVD, physical vapour deposition, sputtering, plating, evaporation, chemical solution deposition and other like deposition processes.

The physical thickness of the high-k dielectric material employed in the present invention may vary depending on the dielectric constant and the deposition process used in forming the same. Typically, however, the high-k dielectric has a physical thickness of from about 50 to about 1000 nm, with a thickness of from about 100 to about 400 nm being preferred.

After making the high-K capacitors a contact to the W plugs can be provided followed by a final H₂-N₂ annealing process. However, the high-K capacitors have to be protected against the H₂ containing atmosphere of the annealing process. For this purpose, the high-K capacitors are encapsulated in a buffer or encapsulation layer 28 as shown in Figure 5.

The encapsulation layer covers the area of the device so as to cover the top/exposed layer of the bi-layer and top electrode layer 22 (and exposed portions) of the capacitors 18. This encapsulation layer can be, for example, PZT-AlOₓ (meaning that the exact stoichiometry of the AlOₓ is not that important) or TEOS-SiN(-TEOS) (or alternating layers of siliconoxides and nitrides), or PZT-TEOS-SiN-TEOS. By employing the buffer or encapsulation layer, the breakdown voltage of the capacitors and the dielectric constant (900-1600) can be maintained even after a subsequent annealing process.

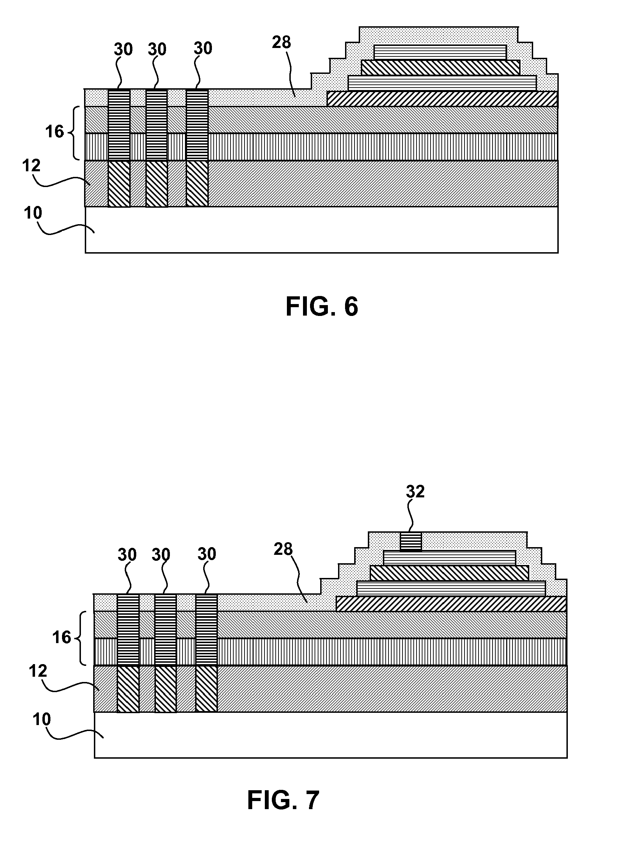

Next, as shown in Figure 6, a plurality of aluminium (Al) plugs 30 are formed in the buffer layer 28 and bi-layer 16 so as to extend through the buffer layer 28 and bi-layer 16 and contact the W plugs 14. In this process contact holes are formed in the buffer layer 28 and bi-layer 16 by plasma etching. Next, after an in situ cleaning step, a layer of typically 500 nm ― 1000 nm Al (alloy) is deposited preferably by PVD (sputtering). Next, this layer is patterned using lithography and plasma etching. An activation annealing process is then carried out in an H₂-N₂ atmosphere in a furnace at 400-450°C (this is the final back-end anneal to activate the W-Al contacts to the underlying BiMos/cmos).

As mentioned above, the encapsulation/buffer ensures that the W plugs will survive the annealing procedure so that the dielectric constant (900-1600) can be maintained.

Finally, after the annealing process, Al contacts 32 to the capacitor(s) are provided as shown in Figure 7.

It will be appreciated that embodiments enable the integration of a high-K capacitor with BiCMOS, BiMOS, CMOS or Bipolar junction transistors while maintaining a high dielectric constant value of a dielectric layer employed for the capacitor.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. Any reference signs in the claims should not be construed as limiting the scope.

## Claims

1. A method of manufacturing a capacitor comprising the steps of:
forming a capacitor having a high-k dielectric layer (20) sandwiched between top (22) and bottom (24) electrodes, the high-k dielectric layer (20) having a dielectric constant greater than 20; and
covering the capacitor (18) with an encapsulation layer (28) so as to protect the high-k dielectric layer (20) from a subsequent annealing process.

2. The method of claim 1, wherein the encapsulation layer (28) comprises a binary metal oxide or a perovskite oxide.

3. The method of claim 1, wherein the encapsulation layer (28) is formed from PZT-AlOₓ, TEOS-SiN or PZT-TEOS-SiN-TEOS.

4. The method of claim 1, wherein the high-k dielectric layer (28) has a dielectric constant greater than 500.

5. The method of claim 1, wherein the bottom electrode (24) is formed on a further high-k dielectric layer (26).

6. The method of claim 5, wherein the further high-k dielectric layer (26) is formed from TiOₓ-PZT.

7. A method of manufacturing a semiconductor device comprising the steps of:
providing a substrate (10);
forming a TEOS layer (12) on the substrate (10);
forming a first plug (14) in the TEOS layer (12) so as to contact the substrate (10);
covering the TEOS layer (12) and the first plug (14) with a buffer layer (16) so as to protect the first plug (14) from a subsequent annealing process;
subjecting the buffer layer (16) to an annealing process;
manufacturing a capacitor on the buffer layer (16) according to claim 1;
forming a second plug (30) in the encapsulation layer (28) so as to contact the first plug (14) formed in the TEOS layer;
subjecting the encapsulation layer (28) to an activation annealing process; and
forming a third plug (32) in the encapsulation layer (28) so as to contact an electrode (22) of the capacitor.

8. A capacitor (18) having a high-k dielectric layer (20) sandwiched between top (22) and bottom (24) electrodes, the high-k dielectric layer (20) having a dielectric constant greater than 20, the capacitor (18) being **characterised by** comprising an encapsulation layer (28) adapted to protect the high-k dielectric layer (20) from an annealing process.

9. The capacitor of claim 8, wherein the encapsulation layer (28) comprises a binary metal oxide or a perovskite oxide.

10. The capacitor of claim 8, wherein the encapsulation layer (28) is formed from PZT-AlOₓ, TEOS-SiN or PZT-TEOS-SiN-TEOS.

11. The capacitor of claim 8, wherein the high-k dielectric layer (28) has a dielectric constant greater than 500.

12. A semiconductor device comprising:
a substrate (10); and
a capacitor according to claim 8 formed on the substrate.

13. The semiconductor device of claim 12, wherein the bottom electrode (24) of the capacitor (18) is separated from the substrate (10) by at least one of: a TEOS layer; and a further high-k dielectric layer (26).

14. The semiconductor device of claim 12, further comprising a first plug for contacting the substrate and second plug for contacting an electrode of the capacitor (18).
